(19) Europäisches Patentamt
European Patent Office
Office européen des brevets

(11) EP 0 539 832 B1

(12) # EUROPEAN PATENT SPECIFICATION

(45) Date of publication and mention
of the grant of the patent:
**08.04.1998 Bulletin 1998/15**

(51) Int Cl.6: **H03M 1/66**, G01R 31/28,
H03K 5/13

(21) Application number: **92117854.7**

(22) Date of filing: **19.10.1992**

(54) **CMOS pseudo-NMOS programmable capacitance time vernier system and method for controlled delay of timing edges**

CMOS-pseudo-NMOS programmierbares Kapazitäts-Zeitvernierssystem und Verfahren zur gesteuerten Verzögerung von Zeitflanken

Système et procédé de vernier temporel capacitif programmable pour commande de retard de flancs de temporisation en technologie CMOS pseudo-NMOS

(84) Designated Contracting States:
**DE FR GB**

(30) Priority: **01.11.1991 US 786695**
**01.11.1991 US 786459**
**01.11.1991 US 786690**
**01.11.1991 US 786633**
**01.11.1991 US 786447**

(43) Date of publication of application:
**05.05.1993 Bulletin 1993/18**

(73) Proprietor: **Hewlett-Packard Company**
**Palo Alto, California 94304 (US)**

(72) Inventors:
• **Koerner, Christopher**
**Longmont, CO 80503 (US)**
• **Gutierrez, Albert, Jr.**
**Fort Collins, CO 80526 (US)**

(74) Representative: **Schoppe, Fritz, Dipl.-Ing.**
**Schoppe & Zimmermann**
**Patentanwälte**
**Postfach 71 08 67**
**81458 München (DE)**

(56) References cited:
**EP-A- 0 423 963**          **GB-A- 2 045 561**

• **IBM TECHNICAL DISCLOSURE BULLETIN, vol.26, no.1, June 1983 LOUNG ET AL 'strobe pulse generator'**

Remarks:
The file contains technical information submitted after the application was filed and not included in this specification

**Description**

**BACKGROUND OF THE INVENTION**

**1. Field of the Invention**

The present invention relates generally to electronic systems where accurate and stable signal edge placement is required. More particularly, in computer test systems for integrated circuit testing, the present invention is directed to a system for adding a time delay to an input signal. The resulting signal is stable (i.e., has low skew) with respect to power supply and temperature changes.

**2. Related Art**

Conventionally, manufacturers of test systems for integrated circuits have used bipolar technology to implement the timing control. However, high power solutions such as those implemented with bipolar technology limit the functionality as compared to a low power technology such as CMOS (Complementary Metal Oxide Semiconductor). Furthermore, high power solutions often require the addition of water cooling in order to maintain a workable system environment.

Those skilled in the art understand that solutions utilizing CMOS technology rather than bipolar technology greatly reduce the system power requirement and may therefore obviate water cooling. CMOS technology offers more functionality at a greatly reduced power.

One aspect of test system development has been the design of vector formatters. A vector formatter generates coarse timing edges used for testing integrated circuits. The inventors have previously designed a vector formatter that provides high performance specifications such as low skew specifications and low jitter specifications on the critical paths of the integrated circuit device. The coarse timing edges generated by vector formatters, however, generally require some fine tuning.

The problems associated with prior designs are illustrated by one implementation which achieves fine tuning by driving the output signal of the vector formatter into a BT605 time vernier (Brooktree Corporation, San Diego, CA). The BT605 performs fine time adjustments to the skew (the relative timing between edges) of the input waveforms. Since the BT605 is implemented in bipolar technology, the design has a high power requirement in comparison to a CMOS implementation.

Additionally, the bipolar solution using a BT605 is limited in bandwidth due to the ramp-comparator technique. The ramp-comparator technique involves charging a capacitor with a constant current producing a voltage ramp, which is subsequently compared to a reference voltage using a comparator. The need to discharge the capacitor between edges results in a limited bandwidth.

Furthermore, the BT605 implementation requires N BT605 circuits, where N is the number of functional test pins times the number of data format types per edge. The power and space requirements of this bipolar implementation are thus multiplied by N.

These power and space requirements could be significantly reduced by eliminating the bipolar time vernier and integrating the functions of the vector formatter and time vernier on one silicon die, fabricated using CMOS technology. The challenge of designing such a system is to design a time vernier using CMOS technology that at least meets the performance of the conventional bipolar circuit. This task is a challenge since bipolar technology is usually considered to have higher bandwidth performance than CMOS technology.

Although some CMOS time vernier designs exist that make fine adjustments in time to coarse timing edges, performance with respect to skew and jitter have been inadequate. (See Branson *et al.'s* article titled "Integrated PIN Electronics for a VLSI Test System," *IEEE International Test Conference, 1988* pp. 23-27.) These existing CMOS designs use multiple delay elements which are tapped or multiplexed to obtain the desired delay. Redundant hardware elements and a large look-up table RAM are needed for calibration. Since the skew and linearity performance of such CMOS integrations of delay lines has been inadequate with respect to market requirements, these CMOS designs have only been used for lower performance systems. Bipolar subsystems which consume high power have therefore been required to implement high performance fine timing generation.

EP-A-423963 relates to a temperature self-compensated time delay circuit. A positive temperature coefficient resistor achieves a temperature compensation of the current flowing through a transistor which has a negative temperature coefficient. As a result, the current is stable and insensitive to variations in temperature.

As the current technology illustrates, a strong need exists in the test system manufacturing industry for a way to integrate low cost, high performance, low power time verniers onto the same chip with a vector formatter. The objective is to eliminate the need for the high-power and potential water-cooling requirements of bipolar parts without suffering any significant loss in performance or functionality. Integration of the vector formatter and time vernier using a low power technology such as CMOS would permit more functionality to be implemented on the chip with greatly reduced power and space requirements.

## SUMMARY OF THE INVENTION

The present invention implements a design using CMOS or an equivalent technology to integrate required time verniers onto the same chip as a vector formatter. The present invention greatly reduces the system power requirements, obviates the need for water cooling, and maintains and exceeds the bipolar time vernier performance. Since an implementation using CMOS technology is very different than an implementation using bipolar technology, the inventors could not use the same types of circuits that were implemented with bipolar technology. As a result, the present invention is directed to a new design using CMOS.

Broadly, the system and method of the present invention structurally provide a way to integrate time verniers onto the same chip using a technology such as CMOS rather than bipolar technology in order to allow for more functionality at greatly reduced power.

The system and method of the present invention function to provide a way to gain much tighter control over reducing the timing variability of logic elements in an integrated circuit due to process, temperature and power supply variations encountered during manufacture and operation of the chip. Specifically, reduced skew is obtained for logic elements implemented in CMOS using pseudo-NMOS (n-channel MOS) circuits. The pseudo-NMOS circuits are so named because they implement ratioed logic as do circuits implemented using NMOS technology. Secondly, the pseudo-NMOS is implemented using a PMOS FET (p-channel MOS Field Effect Transistor) with a control voltage which is analogous to the depletion load in NMOS circuits. As described herein, pseudo-NMOS circuits functionally emulate NMOS circuits even though the pseudo-NMOS circuit is not technically implemented in NMOS.

The present invention has applicability in electronics where edge placement timing is critical. One embodiment is in computer test systems which are utilized for integrated circuit testing. Pseudo-NMOS implementations are utilized for delaying negative timing edges. Further embodiments of the present invention include pseudo-PMOS circuits for controlled delay of positive timing edges. Still further embodiments of the present invention include pseudo-NMOS/PMOS circuits for controlled delay of both negative and positive edges.

In accordance with the present invention, the architecture comprises a current mirror digital-to-analog converter (DAC) which supplies a control voltage to at least one time vernier subsystem on an integrated circuit chip. Since the DAC is implemented as a current mirror, the control voltage from the DAC automatically compensates for temperature and power supply variations experienced by the chip. The time vernier subsystem comprises support storage and decode circuitry for a delay line subsystem. The delay line subsystem comprises delay elements tied together with a wired-OR multiplexer. All critical timing elements are implemented using the above described pseudo-NMOS technology. As a result, the present invention provides a system and method for power supply and temperature compensation and for controlling the delay of coarse timing edges in order to finely tune the coarse edges in time using an implementation that allows for increased functionality at greatly reduced power requirements as compared to conventional approaches.

## FEATURES AND ADVANTAGES OF THE INVENTION

The present invention overcomes the deficiencies of the prior art, as noted above, and further provides for the following advantages.

One advantage of using pseudo-NMOS devices includes the fact that the control voltage can be used to set the speed of the device. In essence, by varying a reference current a user can compensate for process variations, for example. Additionally, pseudo-NMOS circuitry has low skew due to the power supply and temperature compensation as compared to standard CMOS circuits, and thus lends itself to the implementation of high performance VLSI.

Other advantages of the present invention are based on the use of CMOS technology. Since CMOS provides more functionality at a greatly reduced power requirement compared to similar implementations with other technologies requiring more power, this system is more easily integrated with other systems that are implemented using CMOS rather than bipolar technology. Furthermore, the use of CMOS technology eliminates the need for water cooling required for some applications using bipolar parts.

The present invention also provides automated calibration of fabrication process variations and photolithography variations across the integrated circuit chip. The calibration process is controlled by a calibration logger which enables averaging of data in order to statistically improve the calibration accuracy. Furthermore, the calibration logger and delay line are configured such that the circuit may indirectly measure its own delay with respect to a precise timing edge, and thus monitor its own operation during production testing.

The present invention may comprise a plurality of time vernier subsystems integrated with a single digital-to-analog converter to provide the capability of referencing several delay lines per integrated circuit chip to provide fine delays

3

to one or more input signals. The invention provides these fine delay adjustments by digitally programming the capacitance of a buffer.

Finally, the architecture of the present invention allows for higher bandwidth (through-put) as compared to known systems.

Further advantages of the present invention will become apparent to those skilled in the art upon examination of the following drawings and the detailed description.

## BRIEF DESCRIPTION OF THE DRAWINGS

The present invention, as defined in the claims, can be better understood with reference to the text and to the following drawings.

Figure 1 is a high level block diagram of the time vernier system of the present invention;

Figure 2 is a high level block diagram of one of the time vernier subsystems shown in Figure 1 of the present invention;

Figure 3 is a block diagram of one of the delay elements in Figure 2 of the present invention;

Figure 4 is a block diagram of a digital-to-analog converter (DAC) system which can be used in the present invention;

Figure 5 shows a representative logic diagram of a pseudo-NMOS delay element which can be used in the present invention;

Figure 6 shows a representative logic diagram of a pseudo-PMOS delay element which can be used in the present invention;

Figure 7 is a representative logic diagram of a delay line which can be used in the present invention;

Figure 8 is a representative logic diagram of a wired-OR multiplexer which can be used in the present invention;

Figure 9 is a block diagram of a time vernier of the present invention;

Figure 10 is a flow chart of a preferred method of PCNTRL signal calibration utilized in a preferred embodiment of the present invention;

Figure 11 is a flow chart of a preferred method of fine delay calibration utilized in a preferred embodiment of the present invention; and

Figure 12 is a flow chart of a preferred method of coarse delay calibration utilized in a preferred embodiment of the present invention.

## DETAILED DESCRIPTION OF THE PREFERRED EMBODIMENTS

Broadly, the system and method of the present invention provide a way to integrate time verniers onto the same chip using a technology such as CMOS rather than bipolar technology in order to allow for more functionality at greatly reduced power.

The system and method of the present invention function to provide a programmable delay to one or more input signals having coarse timing edges. The programmable delay provided is stable to the first order with respect to power supply and temperature variations. This stability is required to isolate the behavior of a circuit-under-test from that of the tester itself. Specifically, reduced skew is obtained for logic elements implemented in CMOS using pseudo-NMOS (n-channel MOS) Field Effect Transistor (FET) circuits.

The present invention has applicability in electronics where placement in time of a signal's rising or falling edge is critical. One embodiment of this is in computer test systems which are utilized for integrated circuit testing. Pseudo-NMOS implementations are utilized for delaying negative timing edges. Further embodiments of the present invention include pseudo-PMOS circuits for controlled delay of positive timing edges. Still further embodiments of the present invention include pseudo-NMOS/PMOS circuits for controlled delay of both negative and positive edges. This particular delay can be accomplished by either alternating a pseudo-PMOS element and a pseudo-NMOS element or by constructing an element with both PMOS and NMOS control voltages.

The pseudo-NMOS (also referred to as PNMOS) circuits are so named because they implement ratioed logic as do circuits implemented using NMOS technology. The PNMOS is implemented using a p-channel MOSFET with a control voltage which is analogous to depletion mode NMOS FETs. Pseudo-PMOS embodiments implemented using n-channel MOSFETs are also envisioned.

Conventional depletion mode NMOS FETs have a negative threshold voltage, which means that the channel of the FET is conductive with zero volts applied to its gate electrode. With pseudo-NMOS, a control voltage is applied to the gate electrode of a PMOS FET of a standard CMOS device so that the PMOS FET remains conductive at all times. As an example, a pseudo-NMOS inverter is formed by driving the gate of the PMOS FET of a CMOS inverter with a control voltage; hence the PMOS FET remains on. As a result, the CMOS inverter functions similarly to an NMOS inverter where the load FET which is tied to the supply voltage is always on and the input signal is used to control the gate of the NMOS FET of the CMOS inverter. Hence, the pseudo-NMOS device is formed from a standard CMOS device with a PMOS FET and an NMOS FET that emulates a purely NMOS inverter even though it is not technically an NMOS device.

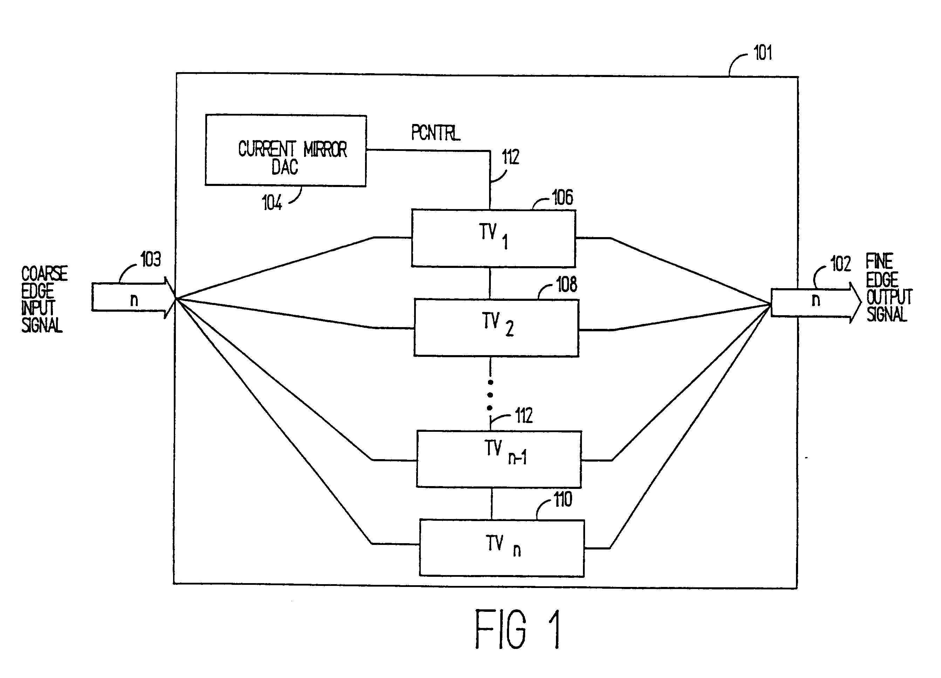

The present invention will now be described with reference to the block diagrams shown in Figures 1 through 12.

Referring to Figure 1, a block diagram is shown of the high level structure of a time vernier system 101, which is used to provide a variable number (n) of well-controlled output signals 102 having finely tuned timing edges from a variable number (n) of input signals 103 having coarse timing edges.

The system 101 is made up of two basic blocks: a current mirror digital-to-analog converter (DAC) 104 and one or more time vernier blocks 106, 108, and 110, referred to as $TV_1$, $TV_2$, and $TV_n$ respectively. Each time vernier 106-110 can be used to delay an input signal 103 to produce a time delayed output signal 102. The n input signals 103 are supplied to one of the time verniers, 106, 108 or 110 for example, in order to adjust the coarse timing edges to provide n output signals 102 having fine tuned time edges.

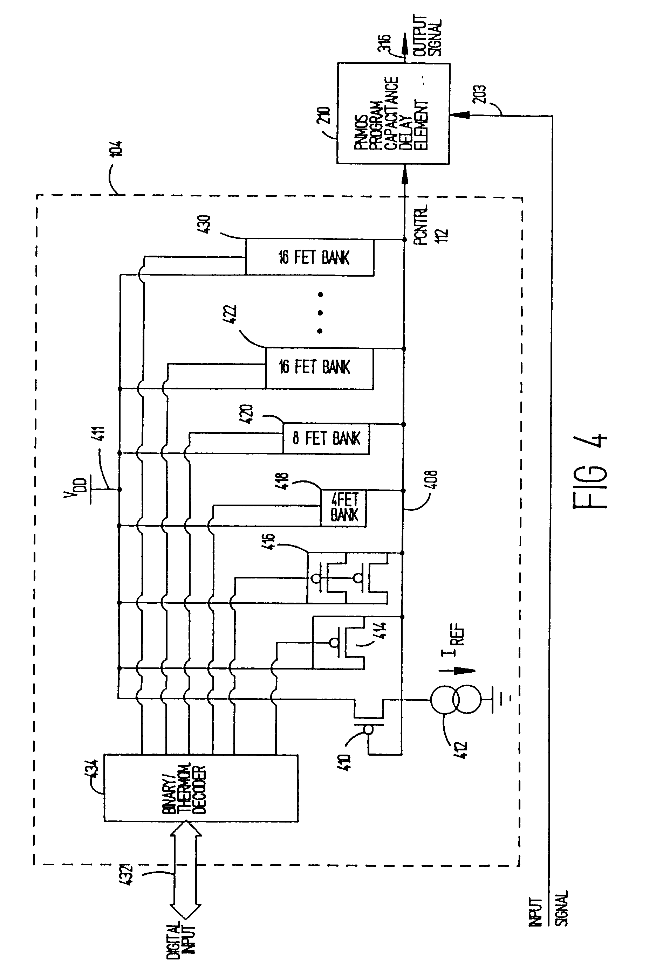

The current mirror DAC 104 generates a control voltage signal (PCNTRL) 112 which automatically compensates for temperature and power supply variations, as will be discussed in detail below in connection with Figure 4. The current mirror DAC 104 is programmable such that the PCNTRL signal 112 can be adjusted so as to provide delay control. This control could also be used to adjust for process variations. The PCNTRL signal 112 is input to each of the time verniers 106,108, 110 which are located on the chip of the time vernier system 101.

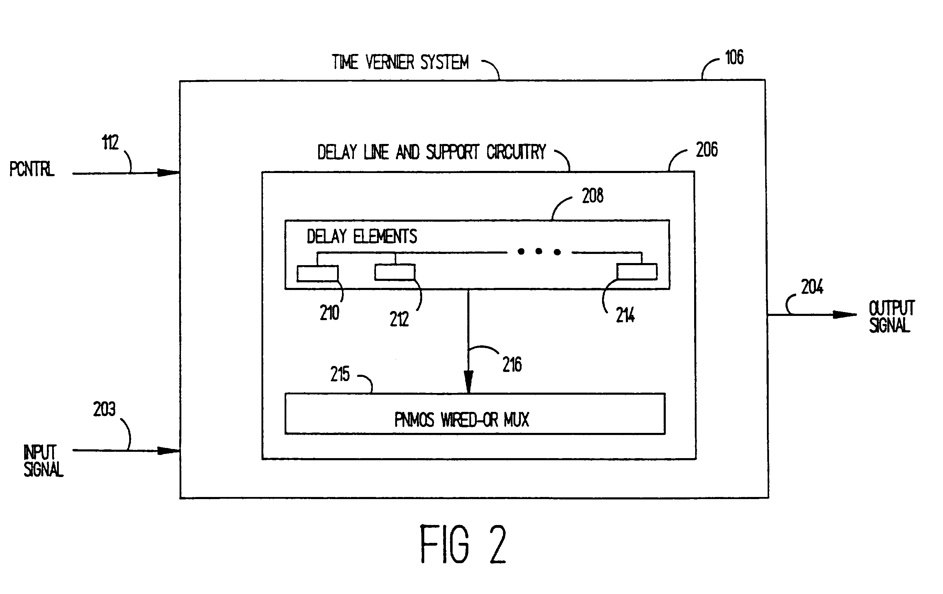

Figure 2 shows a block diagram of one of the time vernier subsystems 106 and its support circuitry. As shown in Figure 2, the time vernier subsystem 106 receives the PCNTRL signal 112 and the data input signal 203 and provides data output signal 204 as a result of the functionality of the time vernier and the support circuitry.

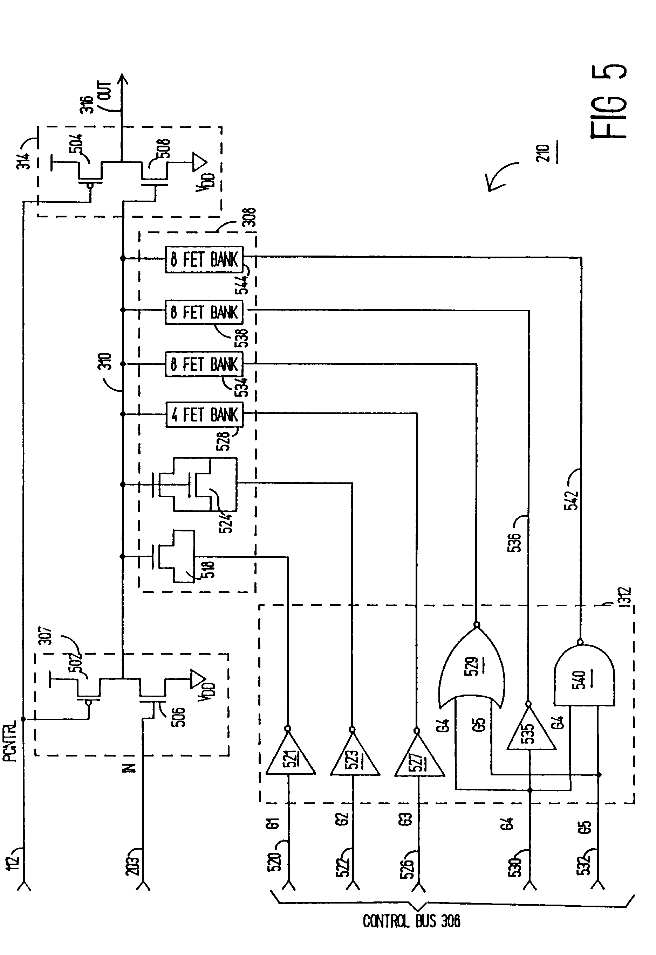

Specifically, the support circuitry for the time vernier 106 includes a delay line 206. The delay line 206 includes block 208 which comprises one or more delay element blocks 210, 212, and 214, as well as a wired-OR multiplexer (MUX) 215. The wired-OR MUX 215 is electrically connected to the delay elements 210-214 via connections 216. The specifics of the delay elements 210 and 212 through 214 and the delay line 206 are discussed in detail below in reference to Figures 5 and 6, and Figures 7 and 8, respectively.

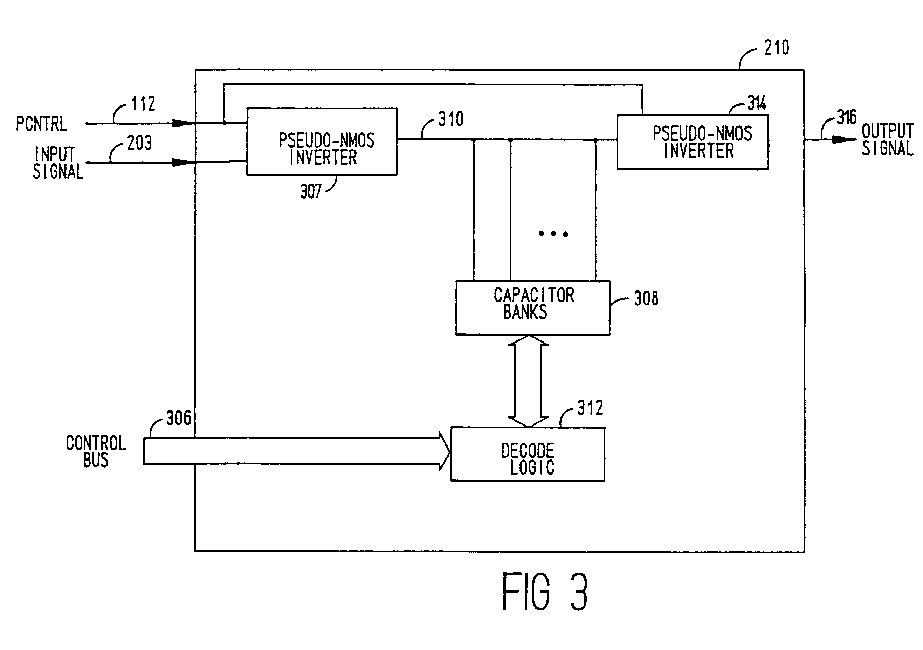

Figure 3 shows a block diagram of one of the delay elements 210 contained in block 208. The delay element 210 functions to add, via digital control, finite amounts of capacitance to finely delay the input signal 203. The delay element 210 receives the PCNTRL signal 112 and the input signal 203 as well as a control bus input 306. The PCNTRL signal 112 is input as a voltage into a pseudo-NMOS inverter 307, which inverts and buffers the input signal 203.

A set of capacitor banks 308 is connected to an internal node 310. The capacitor banks 308 provide programmable capacitance on the internal node 310. Thus, finite amounts of capacitance can be added to the internal node 310 via digital control. Specifically, the capacitor banks 308 are turned on via a binary and thermometer decode logic device 312 fed by the control bus input 306. The decode logic device 312 applies binary control to the capacitor banks 308 according to a specific digital input, as determined by a particular application. The decode logic device 312 additionally provides thermometer decoding to control further capacitor banks in order to reduce non-linearities in the device.

The node 310, which receives the designated amounts of capacitance from capacitor banks 308, is used to control a second pseudo-NMOS inverter 314 which also receives the PCNTRL signal 112 as a control voltage. The signal present at node 310 is again inverted by inverter 314 to provide a delayed, finely tuned output signal 316 having the same logic state as the input signal 203.

Since the DAC 104 is referenced to a stable fixed current source as will be discussed in detail below, the PCNTRL signal 112 automatically adjusts for temperature and power supply variations. In other words, from a theoretical perspective, a "fixed" delay is provided regardless of power supply and temperature variations, therefore providing to the system a unique method of temperature and power supply compensation.

A representative logic diagram of the DAC 104 of the present invention will now be discussed in connection with Figure 4. The DAC 104 is shown connected to a pseudo-NMOS (PNMOS) programmable capacitance delay element 210 via a control voltage or PCNTRL signal 112 tapped off of node 408. The DAC 104 comprises a PMOS FET 410 with the gate and drain connected to an analog current source 412. These connections create the node 408 which automatically adjusts to mirror the same amount of current ($I_{REF}$) supplied by current source 412.

A plurality of PMOS FET banks 414, 416, 418, 420, 422 and 430 are switchably connected to the node 408 of the DAC 104 in order to enable small voltage adjustments to be made to node 408. In a preferred embodiment, bank 414 contains one FET, bank 416 contains two FETs, bank 418 contains four FETs, bank 420 contains eight FETs, and banks 422-430 each contain sixteen FETs.

The voltage adjustments are controlled via a digital input 432, which specifies in a digital format the adjustment required. As illustrated by a decoder 434, the digital input 432 is decoded to switchably connect selected FET banks to the node 408. This permits amounts of FET width from banks 414-430 to be added to the width of PMOS FET 410. The output line from the decoder 434 that corresponds to the bank 414 represents the least significant bit (LSB) and the line corresponding to the bank 430 represents the most significant bit (MSB). The current mirrored to the PNMOS delay element 210 is specified by the width-to-length ratio of the total number of selected PMOS FETs in the DAC 104 and the width-to-length ratio of the PNMOS delay element 210. This relationship is shown in equation form below:

$$I_{mirrored} = \frac{(W_{PNMOS} / L_{PNMOS})}{(W_{DAC} / L_{DAC})} * I_{REF} \qquad [Assuming\ Saturation]$$

The current mirror DAC 104 FET width is variable as represented by the expression below:

$$W_{DAC} = W_O + NW_i$$

where:

$W_0$ = the initial equivalent channel width for the system
N = the value of digital input 432, and
$W_i$ = the channel width of the LSB FET

Therefore, the mirrored current becomes:

$$I_{mirrored} = \frac{W_{PNMOS} / L_{PNMOS}}{(W_O + NW_i) / L_{DAC}} * I_{REF}$$

These equations assume that all respective FETs are in saturation, which is not always true. Nonetheless, these equations are useful to illustrate the DAC system operation.

Since the output voltage (PCNTRL 112) is controlled by a current mirror, the DAC 104 compensates for temperature and power supply changes such that the $I_{REF}$ is reflected as indicated in the equations above.

Two different forms of decoding are utilized by the decoder 434. In the preferred embodiment, a multitude of PMOS FET banks are connected to the DAC 104 at node 408. PMOS FET banks 420-430 provide the MSB (Most Significant Bits) for the current mirror. These bits are decoded using a thermometer decoding method, which decodes in incremental units with no binary weighing. An example of thermometer decoding for values 0 through 3 is shown in Table 1:

TABLE 1

| Digital Value | Decoded Result |
|---|---|
| 0 | All bits OFF. |
| 1 | 1st bit ON; stay on. |
| 2 | 2nd bit ON in addition to 1st; stay on. |
| 3 | 3rd bit ON in addition to 1st and 2nd. Note that 3 bits go ON. |

In contrast, PMOS FET Banks 414-418 provide the LSBs (Least Significant Bits) for the current mirror. These banks are selected using a binary decoding method, which decodes according to standard binary weighing.

The dividing point between binary and thermometer decoding is determined by the specific application. In a preferred embodiment, the dividing point at the FET banks consisting of 16 PMOS FETs gives a 16-to-1 MSB-to-LSB ratio. This ratio is in contrast to a 64-to-1 MSB-to-LSB ratio if strict binary decoding had been used throughout the entire group of FET banks. The net effect is that the device mismatch due to processing is reduced to a 16-to-1 MSB-to-LSB ratio.

The voltage at the node 408 increases non-linearly with N, where N is the value of the digital input 432. The PCNTRL signal 112 generated at the node 408 is connected to the variable capacitance delay element 210 to enable the delay element 210 to provide a specified delay to an input signal 203 having coarse timing edges. As will be discussed below, delay element 210 provides finely tuned output signal 316 (see Figure 3).

As a function of the digital input 432 and the PCNTRL signal 112 (the mirrored current at node 408) are inversely proportional to N as follows:

$$I_{mirrored} = \frac{W_{PNMOS} / L_{PNMOS}}{(W_O + NW_i) / L_{DAC}} * I_{REF} \qquad [Assumes\ Saturation]$$

$$(V_{GS} - V_T)^2 = \frac{I_{REF}}{\dfrac{K(W_o + NW_i)}{L_{DAC}}} \qquad [Assumes\ Saturation]$$

where $V_{GS}$ is equivalent to the PCNTRL signal 112 referenced to a positive voltage supply 411, and $V_T$ is the threshold voltage of the PMOS FET 410 and the PMOS FET banks 414-430.

However, although both the voltage and the current from the DAC 104 are inversely related to N, the delay reflected to the delay element 210 is proportional to the digital input 432. This feature of the present invention is best illustrated by considering the amount of time necessary to charge a capacitor C with a constant current:

$$I = \frac{CdV}{dt}$$

or approximately:

$$\Delta T = \frac{C\Delta V}{I}$$

Substituting the mirrored current from the DAC 104 for I in the above equation gives:

$$\Delta T = \frac{C\Delta V}{\dfrac{(W_{PNMOS} / L_{PNMOS})}{(W_O + NW_i) / L_{DAC}} * I_{REF}}$$

or:

$$\Delta T = \frac{C\Delta V}{I_{REF}} * \frac{(W_O + NW_i) / L_{DAC}}{W_{PNMOS} / L_{PNMOS}}$$

Therefore, the linear delay for the above situation is given by an intrinsic delay:

$$(\frac{C\Delta V}{I_{REF}} * \frac{W_O / L_{DAC}}{W_{PNMOS} / L_{PNMOS}})$$

plus a discrete amount of delay:

$$(\frac{NC\Delta V}{I_{REF}} * \frac{W_i / L_{DAC}}{W_{PNMOS} / L_{PNMOS}})$$

added by the digital programming from the digital input 432.

The delay element 210 of the present invention, shown in Figure 5 will now be discussed. The basic architecture of the delay element 210 comprises a pseudo-NMOS or -PMOS buffer, which is made up of two pseudo-NMOS or -PMOS inverters 307 and 314 with a programmable capacitance 308 added to an internal node 310 between the inverters 307 and 314.

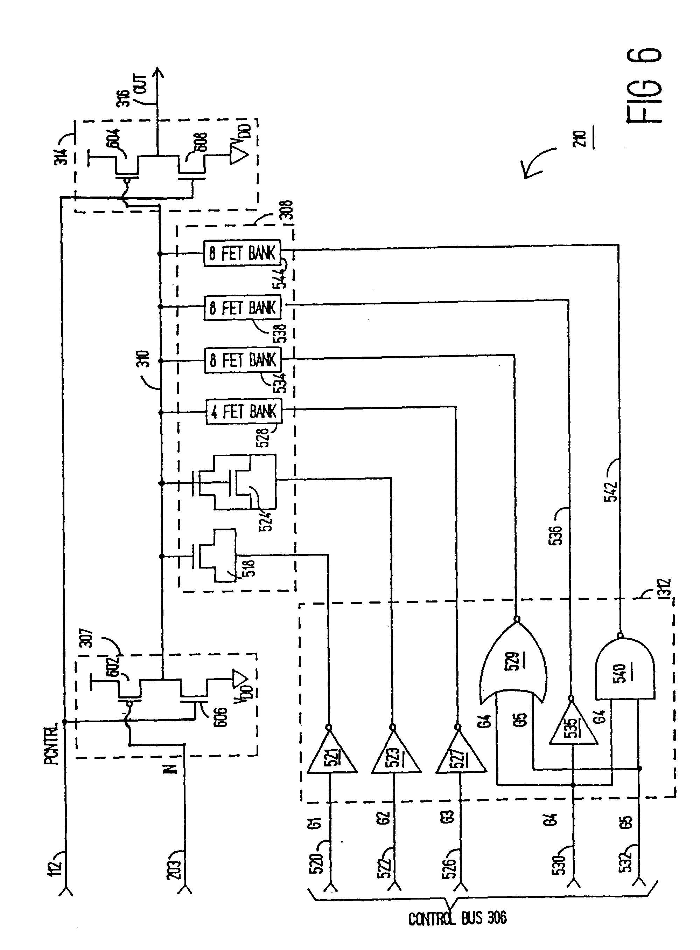

The pseudo-NMOS circuit shown in Figure 5 provides fine tuning of a negative timing edge of an input signal 203. A pseudo-PMOS circuit is shown in Figure 6 and provides fine tuning of a positive timing edge of the input signal 203. Like reference numbers in these figures indicate identical or functionally similar elements.

The gates of PMOS FETs 502 and 504 of the pseudo-NMOS inverter embodiment shown in Figure 5 and NMOS FETs 606 and 608 of the pseudo-PMOS inverter embodiment shown in Figure 6 are driven by the PCNTRL signal 112 generated by the DAC 104. As discussed above, an independent variable N represents the digital input 432 to the DAC and the transfer function between the output signal of the current mirror and the digital input is inversely related to N. Since the DAC is referenced to a stable fixed current source, the PCNTRL signal 112 automatically adjusts to temperature and power supply variations. Therefore, temperature and power supply compensation is provided for the pseudo-NMOS or -PMOS inverters.

The PCNTRL signal 112 regulates the charging current (current mirrored from the DAC) into the variable capacitance 308 and is used for adjusting the delay of the buffer 210. For the present invention, the PCNTRL signal 112 is also used for nulling process variations and thus obtaining a nominal time delay. By changing the mirror ratio of the DAC, the charging current changes. The time to charge the internal node is inversely proportional to the charging current. However, the charging current is inversely proportional to the DAC FET width. Therefore, the end result is that the delay increases proportionately to the DAC FET width, as mentioned above.

The variable capacitance 308 in connection with the present invention is obtained by modulating the gate-source voltage ($V_{GSS}$ of one or more NMOS FETs. The gate of each NMOS FET is connected to the internal node 310 of the buffer 210. The source and drain electrodes are shorted together. The gate capacitance is effectively switched in or out of the circuit by driving the source-drain node to the negative or positive supply voltage, respectively. Thus, small finely controlled amounts of capacitance can be added to the internal node 310 via digital control. As is evident to those skilled in the art, the size of the capacitor FET is chosen corresponding to the fine timing resolution required by an application of the present invention. The number of of capacitors attached to the internal node is determined by the dynamic range requirements. Since the delay of the element is linearly proportional to the capacitance of the internal node, this technique offers a linear relationship between the programmed capacitor setting and the delay of the circuit. For the present invention, the higher order capacitors are implemented as capacitor banks in order to reduce non-linearities.

The pseudo-NMOS implementation in Figure 5 is utilized for delaying negative timing edges. Further embodiments of the present invention include pseudo-PMOS circuits for controlled delay of positive timing edges (see Figure 6). Still further embodiments of the present invention include pseudo-NMOS/PMOS circuits for controlled delay of both negative and positive edges. This particular delay can be accomplished by either alternating a pseudo-PMOS (PPMOS) element and a pseudo-NMOS (PNMOS) element or by constructing an element with both PMOS and NMOS control voltages.

Referring again to Figure 5, the PNMOS delay element 210 comprises inverter 307 and inverter 314, and various capacitor banks 518, 524, 528, 534, 538 and 544, which are shown generally at 308, driven by decode circuitry 312 and connected in parallel to an internal node 310.

The inverter 307 comprises PMOS FET 502, the gate electrode of which is connected to PCNTRL signal 112. The PMOS FET 502 always remains on, but its conductance is adjustable by changing the voltage of the PCNTRL signal 112. Adjusting this voltage modulates the charging of the capacitance on the internal node 310.

The inverter 307 also comprises an NMOS FET 506, which receives input signal 203 connected to its gate electrode. The PMOS FET 502 and the NMOS FET 506 function together to invert the input signal 203. An inverted output signal from the inverter 307 is delayed on node 310 by the previously mentioned capacitor banks 308 that are switchably connected to the node.

The lower order capacitor banks (FET banks comprised of less than 8 FETs) are rendered active by control signals G1-G3 (see lines 520, 522 and 526, respectively). Once active, i.e., turned on, the FETs act like capacitors and sink charge from the node 310 to thereby delay a signal propagating from inverter 307 to invertor 314. Control signals G1-G3 are Boolean coded to apply additional capacitance to the node 310 in a linear fashion. The higher order bits (FET banks comprised of 8 or more FETs) are rendered active by control signals G4 and G5 (see lines 530 and 532, respectively). The control signals G4 and G5 are thermometer encoded to minimize device mismatch due to process tolerances. Lines 520, 522, 526, 530 and 532 comprise the control bus 306 discussed above in connection with Figure 3.

A first capacitor bank 518 comprises one NMOS FET with its gate connected in parallel to the node 310 as well as a short-circuited source-drain node which is controlled by a gate-control input signal G1 on line 520. G1 is logically inverted and buffered by an inverter 521. The input signal G1 is the Least Significant Bit (LSB) of the control word comprising input signals G1-G5. The gate-control input signal G2 on line 522 is inverted and buffered by an inverter 523 and controls the short-circuited source-drain node of a pair of parallel connected FETs forming the capacitor bank 524. The capacitor bank 524 is connected to the node 310 so as to control the next significant bit on the node. A gate-control input signal G3 on line 526, which is inverted by an inverter 527, controls a group of four FETS forming a capacitor bank 528. Capacitor bank 528 is connected in parallel to the node 310 via the gates of capacitor bank 528 so as to control the next significant bit of the node.

A logical NOR gate 529 of a gate-control input signal G4 on line 530 and gate-control input signal G5 on line 532 controls the source-drain node of a capacitor bank 534. Bank 534 comprises eight NMOS FETs that provide the next significant bit of delay to node 310. An inverter 535 provides an inverted output signal 536 of the gate-control input signal G4. Output signal 536 controls the source-drain node of a capacitor bank 538, comprising eight NMOS FETs that provide a capacitance delay for the next significant bit on the node 310. Gate-control input signals G4 and G5 are applied to respective inputs of a logical NAND gate 540. An output signal 542 of logical NAND 540 controls the source-drain node of a capacitor bank 544. The capacitor bank 544 comprises eight NMOS FETs that provide a capacitance delay for the MSB (Most Significant Bit) to node 310.

Note that the FETs of the first four capacitor banks are arranged in a binary fashion, (1, 2, 4, 8) so as to achieve the programmed capacitance capabilities offered by a binary decode provided to inputs G1 through G3. The two MSBs, G4 and G5, are decoded in a thermometer fashion such that capacitor bank 308 consists of eight NMOS FETs instead of the next binary equivalent of sixteen. The thermometer decode is such that the three 8 FET capacitor banks, 534, 538 and 544, turn on monotonically as the input signal G4 and the input signal G5 increase from a binary zero $(00_2)$ to a binary three $(11_2)$.

The delayed signal on node 310 provided by the capacitor banks 308 is an input signal to the gate of an NMOS FET 508 of the inverter 314. The inverter 314 comprises the NMOS FET 508 and the PMOS FET 504, with the PCNTRL signal 112 connected to the gate of the PMOS FET 504 so that its conductivity is adjustable. The delayed data signal on node 310 is then reinverted to provide a data output signal 316 (OUT) which is logically consistent with the data input signal 203 (IN).

Referring again to Figure 6, the pseudo-PMOS delay element has the input 203 connected to the gate of the p-channel FET 602 of the first inverter 307. The output of the first inverter 307 is connected to the gate of the p-channel FET 604 of the second inverter 314, and the PCNTRL signal 112 is connected to the gate of the n-channel FETs 606 and 608. This reversal of the control signal and input signals permits controlled delay of positive timing edges.

The delay line 206 of the present invention will now be discussed. The delay line is a structural combination of delay elements 210 electrically coupled to a PNMOS wired-OR multiplexer (MUX) 215 (see Figure 2). Specifically, a group of delay elements are serially arranged so that the data output from one delay element is connected to the data input of a next delay element. A portion of this group of stacked delay elements is used to add fine increments of delay to an input timing edge and another portion of this group of stacked delay elements is used to add coarse increments of delay. A further portion of this group may be used for calibration.

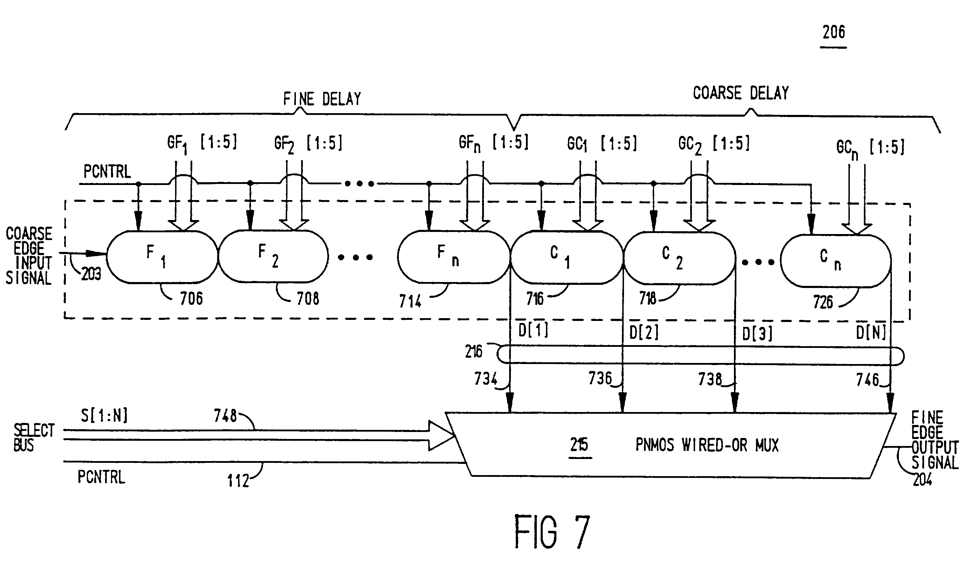

Referring now to Figure 7, a logic diagram is shown of the high level structure comprising a preferred embodiment of a delay line 210 of the present invention. The delay line 206 comprises serially connected delay elements 706-726 and a PNMOS wired-OR MUX 215. The delay elements 706,708 and 714 comprise fine delay elements $F_1$, $F_2$, ... $F_n$ and delay elements 716, 718 and 726 comprise coarse delay elements $C_1$, $C_2$, ..., $C_n$. The input signal 203 which has coarse timing edges is applied to the input of element 706.

The number of delay elements is determined by the desired application of the delay line 206. The number of fine delay elements ($F_1$, $F_2$, ..., $F_n$) is chosen such that the combined range of the fine delay elements covers one coarse delay, but does not exceed a maximum intrinsic delay specification such that:

$$Intrinsic\_delay = Fine\_intrinsic\_delay + MUX\_delay$$

$$Total\_delay = Intrinsic\_delay$$

$$+ Fine\_programmed\_delay$$

$$+ Coarse\_programmed\_delay$$

Each fine delay element has a control input $GF_{1-n}[1:5]$ which corresponds to control bus 306 of Figure 3 and lines G1-G5 of Figures 5 and 6. The control inputs $GF_{1-n}[1:5]$ specify the amount of delay to be added by the corresponding fine delay element. Similarly, each coarse delay element has a control input $GC_{1-n}[1:5]$ which specify the amount of delay to be added by the corresponding coarse delay element.

The final fine delay element $F_i$ and all coarse delay elements 716-726 are tapped off at their respective outputs D[1], D[2], D[N], by the PNMOS wired-OR MUX 215. A nominal coarse delay is set for each coarse delay element by controlling the respective capacitor banks. Therefore, the PNMOS wired-OR MUX 215 functions to tap off the incident edge after an integer number S[1:N] of nominal coarse delays have been added to the incident edge, as specified by the select bus 748.

The select bus 748 provides individual digital control for each of the tapped output signals D[1]-D[N] which are received by the PNMOS wired-OR MUX 215. The bit size of the select bus 748 is determined by the particular application. In addition, the PNMOS wired-OR MUX 215 receives PCNTRL signal 112 which functions to control the PMOS gates of the pseudo-NMOS implementation of the PNMOS wired-OR MUX 215.

The delay line 206 enables the fine delay generated by the delay elements $F_1$,... $F_n$ to be combined with the coarse delay generated by the coarse delay elements $C_1$ ... $C_n$. Therefore, the Fine Edge (FE) output signal 204 is derived from the coarse edge (CE) input 203 after adding an appropriate amount of fine and coarse delay. The FE output signal 204 also has a constant intrinsic delay component added by the fine delay and the PNMOS wired-OR MUX 215.

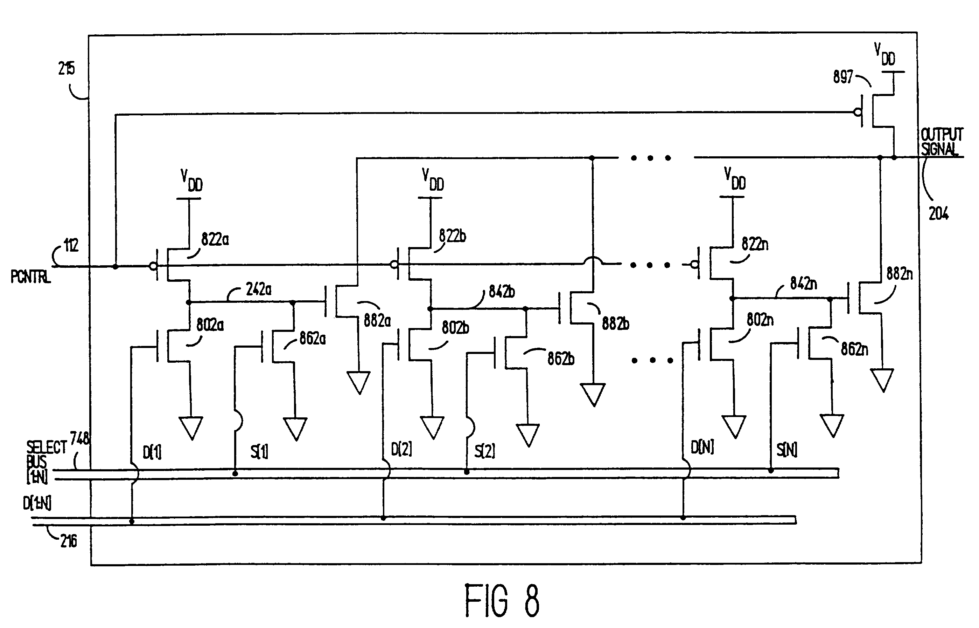

Figure 8 shows a Field Effect Transistor (FET) level diagram of a multiplexer embodiment of the PNMOS wired-OR MUX 215 of Figure 7 of the present invention. The PNMOS wired-OR MUX 215 is implemented using pseudo-NMOS technology. The bus 216 provides the desired input to MUX 215 from any number (N) of the delay input signals D[1], D[2], ... D[N]. The PNMOS wired-OR MUX 215 receives PCNTRL signal 112 to control the PMOS gates of the pseudo-NMOS implementation of the PNMOS wired-OR MUX 215. A select bus 748 of N inputs (S[1:N]), provides a digital control to select any of the N delay input signals D[1], D[2], ... D[N].

A plurality of NMOS FETs 802a, 802b, ..., 802n are connected to corresponding PMOS FETs 822a, 822b, ..., 822n, to form inverted output nodes 842a, 842b, ..., 842n. Each individual delay input signal D[1] - D[N] is connected to the gate of a corresponding NMOS FET 802. In this PNMOS implementation of the PNMOS wired-OR MUX 215, each PMOS FET 822 is controlled by PCNTRL signal 112, which thereby provides the same process, power supply and temperature compensation characteristics of pseudo-NMOS.

Each inverted output node 842 is selectable with a signal S[1:N] via select bus 748, which controls an NMOS FET 862a, 862b, ..., 862n connected in parallel to the respective nodes 842. The individual lines on the select bus 748 are negative true and only one select line (S[i], L = 1 to n) is permitted to be active at one time.

Finally, the digitally selected node 842, which carries an inverted delay input D[1]-D[N], respectively, is connected to a corresponding NMOS FET 882a, 882b, ..., 882n. Each of these NMOS FETs 882 is connected in parallel to a PMOS FET 897 to form a second inverter which reinverts the selected inverted delay input D[1]-D[N] at respective nodes 842 to provide an output signal 204 that is logically consistent with the delay input D[1]-D[N] which was selected by the select bus 748.

To summarize, the PNMOS wired-OR MUX 215 comprises PNMOS OR circuits each with an open drain output. The open drain outputs are all electrically connected to a single PMOS pull-up FET 897 whose gate is driven by the PCNTRL signal 112. One input of each PNMOS OR is driven by a delay line tap. The other input of each PNMOS OR is driven by a select input which functions to enable or disable the particular tap. In one embodiment of the present invention only one tap may be enabled at a time. Upon an incident edge on the enabled tap, the signal will then propagate through the PNMOS OR circuit and pull down the common PMOS pull-up FET, thus propagating the tapped signal to the output of the MUX. The common pull-up FET with all open drain nodes "wired" (electrically connected) to it acts as an OR gate (wired-OR) allowing the active tap to propagate to the output.

Because the present invention has applicability in Integrated Circuit (IC) test environments that require an ability to compensate for temperature, power supply and process variations, it is necessary to be able to isolate the behavior of a circuit-under-test from that of the test system. Therefore, the architecture provides a method of calibration using a pseudo-NMOS (called PNMOS) Fine/Coarse wired-OR Tapped Delay Line and supporting circuitry.

The support circuitry comprises: 1) a data register which receives a digital value representing a desired time delay to be added to an input signal having coarse timing edges; 2) a RAM which provides the calibration memory for the fine delay aspect of the programmed digital delay; 3) a register bank which provides the calibration memory for the coarse delay aspect of the programmed digital delay; 4) decode circuitry for each of the fine and coarse aspects of the programmed digital delay to be input to the PNMOS wired-OR Tapped Delay Line to obtain a desired fine edge (FE) output signal; and 5) calibration circuitry to support various calibration procedures.

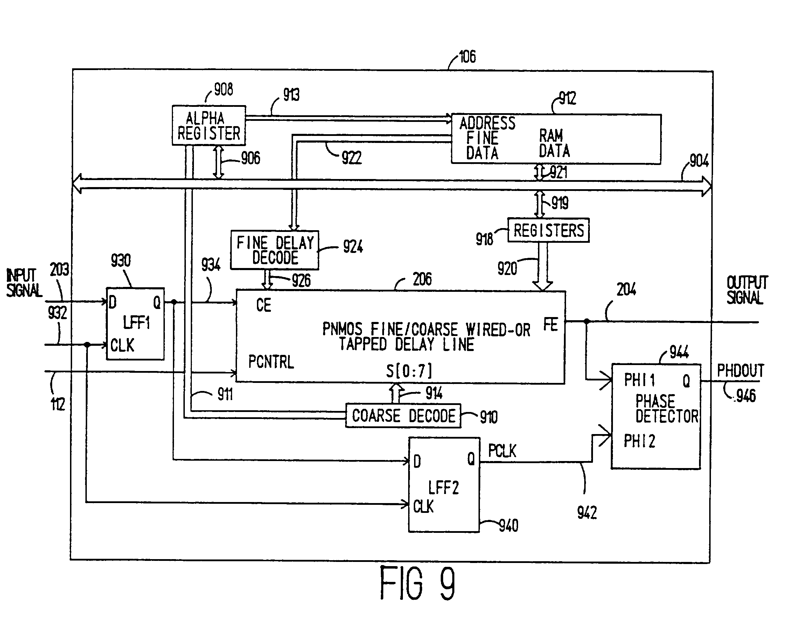

Figure 9 shows a block diagram of a time vernier 106, which is used to provide a well-controlled fine timing edge output from a coarse timing edge input. A data bus 904 provides an input data signal 906 to an alpha register 908. The input data signal 906 specifies a desired programmed digital delay which is stored in the alpha register 908. The Most Significant Bits (MSBs) of the value stored in alpha register 908 are received by a coarse decode 910 via bus 911. The Least Significant Bits (LSBs) of the value in alpha register 908, which define the fine delay to be provided by the time vernier 106, are received as an address to a RAM 912 via bus 913.

The coarse decode 910 decodes the MSBs of the value stored in alpha register 908 to provide a select input 914 to a PNMOS wired-OR Tapped Delay Line 206. The PNMOS wire-OR Tapped Delay Line 206 selects a single tap into the delay line, and thus functions to combine the fine and coarse delays specified by input data signal 906. Register bank 918 provides storage, accessible from the data bus 904 via a bus 919 and to the PNMOS wired-OR Tapped Delay Line 206 via a bus 920, for the calibration data required by the coarse delay elements that internally make up a portion of the PNMOS wired-OR Tapped Delay Line 206.

The RAM 912 provides storage for the calibration data for the fine delay specified by the Least Significant Bits (LSBs) of the value stored in alpha register 908. A bus 921 provides access from the data bus 904 to the RAM 912. A bus 922 provides access from the RAM 912 to a fine delay decoder 924, which functions to decode the RAM 912 binary data into a combination of binary and thermometer decoding. This combined decoding provides improved linearity. Thermometer decoding is used among the multitude of delay elements (inter-delay-element) which comprise the PNMOS wired-OR Tapped Delay Line 206. Binary decoding is used within each delay element (intra-delay-element) which comprise the PNMOS wired-OR Delay Line 206. Bus 926 provides access from the fine delay decoder 924 to the PNMOS wired-OR Delay Line 206.

Further referring to Figure 9, an input signal 203 having coarse timing edges or to which some time delay is to be added, is input along with a system clock signal CLK 932 to a Last-Flip-Flop-1 (LFF1) 930. The output stage of LFF1 930 is implemented in PNMOS in order to gain power supply and temperature compensation. The input signal 203 is clocked to generate a CE (Coarse Edge) signal 934 to be input to the PNMOS wired-OR Tapped Delay Line 206 of the time vernier 106. The PNMOS wired-OR Tapped Delay Line 206 also receives a PCNTRL signal 112 as a control voltage for the PNMOS implementation. A well-controlled delay edge corresponding to the programmed delay received via input data signal 906 is output as a fine edge (FE) output signal 204.

Additionally, the CE signal 934 is input to the D-input of a LFF2 (Last-Flip-Flop-2) 940, which is also clocked by the signal CLK 932. The LFF2 940 is structurally identical to the LFF1 930 because the delay characteristics of LFF2 940 should match those characteristics of LFF1 930. On a next signal CLK 932 after receiving the CE signal 934, the LFF2 940 provides a reference edge signal PCLK 942 to a phase detector 944. This phase detector 944 also receives the FE signal 204. The phase detector 944 compares the period of signal CLK 932 to the delay line delay determined from FE signal 204. A PHDOUT output signal 946 specifies a logic "1" if the delay line delay indicated by FE signal 204 is less than one clock period of signal PCLK 942; otherwise, the PHDOUT output signal 946 specifies a logic "0".

Calibration may be required for several reasons. The need for calibration includes process variations from different lots of the same chip or device mismatches on the same chip. The architecture of the present invention supports three preferred calibration procedures: 1) PCNTRL calibration, which compensates for process variations; 2) Fine Delay calibration, which compensates for device mismatch in the fine delay elements; and 3) Coarse Delay calibration, which compensates for device mismatch in the coarse delay elements. Depending on the particular system requirements, some or all of the above calibration procedures may or may not be required.

Each of the above calibration procedures requires a precise time reference. This time reference comes in the form of a finely controlled, conventional clock period, signal CLK 932 of Figure 9. The method of calibration is controlled by a digital control circuit (calibration logger) and enables averaging of data in order to statistically improve the calibration. Those skilled in the art will readily perceive many conventional techniques to accomplish the storage and counting of the calibration logger. The specifics of the calibration logger are not necessary for one skilled in the art to carry out the present invention. The calibration logger may comprise several counters and registers, and digital logic or the like. The purpose of the logger circuit is to monitor and store a total count of the several phase detector output results and compare them to a threshold value that has been previously programmed into the calibration logger. This compare enables the calibration logger to determine whether the timing edge in question has the desired timing. The calibration logger also provides for a means for the circuit to indirectly make a sensitive timing measurement, and thus, to test itself during production testing.

The calibration procedure can be described by referring to two consecutive rising edges of the clock CLK 932 in Figure 9. The first edge drives CE into the delay line 206 and also sets up a second flip-flop, LFF2 940. The LFF2 940 is clocked by CLK 932 and generates an output PCLK 942, which subsequently becomes a second clock which drives the phase detector. Therefore, when the period, which is the time between two consecutive rising edges of the clock CLK 932, is programmed to be the delay desired by the delay line 206, then the FE output 204 goes high at the same time that the second clock, PCLK 942, has its rising edge. If the FE output 204 signal edge and the PCLK 942 signal edge do not line up as indicated above, FE output 204 is out of calibration. In this situation the delay line 206 setting is adjusted until the FE output 204 signal edge and the PCLK 942 signal edge line up as indicated above. The results of this calibration process are stored in the RAM 912, the registers 918, or used to adjust the DAC setting, depending on whether Fine Calibration, Coarse Calibration, or PCNTRL signal 112, respectively, is being calibrated. In essence, PHDOUT 946 drives a feedback section that emulates a phase-locked loop function and enables calibration of the present invention to be performed through constant digital adjustment of the period of the clock until it matches the desired delay through the delay line 206.

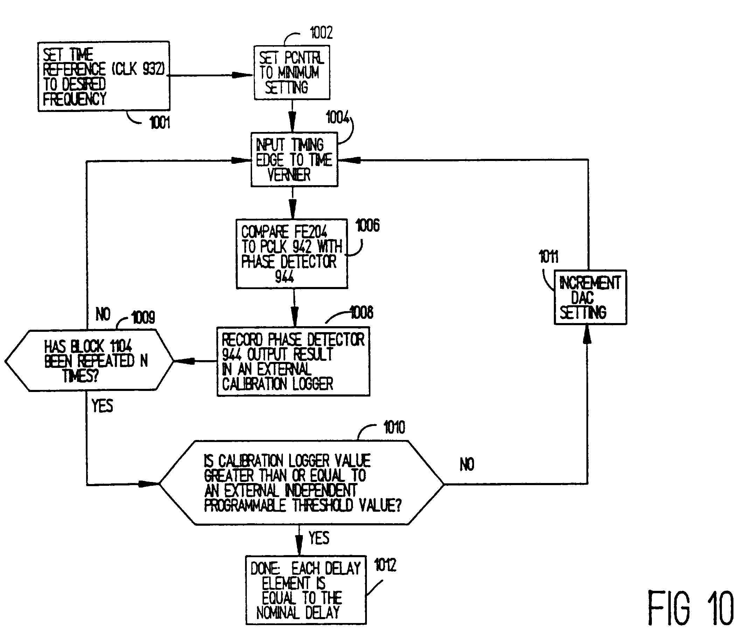

Figures 10, 11 and 12 show flow charts of methods of calibration to be utilized with a preferred embodiment of the present invention illustrated in Figure 9. Figure 10 is a flow chart of a method of PCNTRL calibration which compensates for process variations.

Referring to Figure 10, a PCNTRL signal 112 calibration procedure programs all of the delay elements internal to the PNMOS wired-OR Tapped Delay Line 206 to a nominal capacitor setting. The PCNTRL calibration procedure begins with block 1001 by setting a time reference (CLK 932) to a desired frequency. As an ongoing example to assist in explaining this method, if a desired delay to be calibrated is 8 ns, then the time reference CLK 932 should be set with a period of 8 ns. This setting means that the time between one rising edge and a consecutive rising edge is 8 ns. Note in the ongoing example that if each delay element of the delay line 206 has a 2 ns nominal delay, then four delay elements would be needed in order for the delay line 206 to provide the desired delay of 8 ns. The DAC 104, which generates the PCNTRL signal 112 to be calibrated, is then set to its lowest setting as shown in block 1002, in order to generate the minimum PCNTRL signal 112. Note in the ongoing example that this minimum setting for the PCNTRL signal 112 must enable the delay line 206 to generate a delay which is less than the 8 ns desired delay so that the 8 ns desired delay may be approached by slowly incrementing the PCNTRL signal 112.

Next, block 1004 indicates that a timing edge is input to the time vernier 106 via the input signal 203. Block 1006 illustrates that the delayed edge, FE output 204, is compared to the PCLK 942 (which is generated from time reference CLK 932 and has an identical clock period) by the phase detector 944. As mentioned in the description of Figure 9, the PHDOUT output signal 946 specifies a logic "1" if the delay from the delay line 206 on FE signal 204 is less than one clock period of PCLK signal 942; otherwise, the PHDOUT output signal 946 specifies a logic "0". The external calibration logger then records the PHDOUT output signal 946 as indicated by block 1008, thereby counting the number of times the output is high.

Decision block 1009 indicates that the process from block 1004 is repeated N times, where N is a digital number programmed into the calibration logger. The repeat of this cycle from block 1004 to 1009 is necessary when the delay of the delay line 206 approaches the period of the time reference CLK 932, because at this point the phase detector 944 enters an instability mode where the output becomes uncertain; therefore the output must be determined by probability. Hence, as N increases, the probability that the correct output is correctly determined increases.

At the point when the correct output has reasonably been determined through N successive iterations, decision block 1010 determines if the count value stored as a calibration logger value, which represents the total number of times that the phase detector 944 returned a "1" result, is greater than or equal to an external independent programmable threshold value. If so, as shown by block 1012, each delay element is equal to the nominal delay, which means that the delay of the delay line 206 is calibrated to approximate the delay specified by the period of the time reference CLK 932. Therefore, the PCNTRL signal 112 is now calibrated with respect to fabrication process variations.

Otherwise, as shown by the "No" branch from block 1010, the setting of the DAC 104, which controls the PCNTRL signal 112, is incremented by 1 LSB so as to increase the PCNTRL signal 112 and thereby increase the delay provided by each delay element comprising the delay line 206. The procedure is repeated from block 1004 until decision block 1010 follows the "Yes" branch to block 1012.

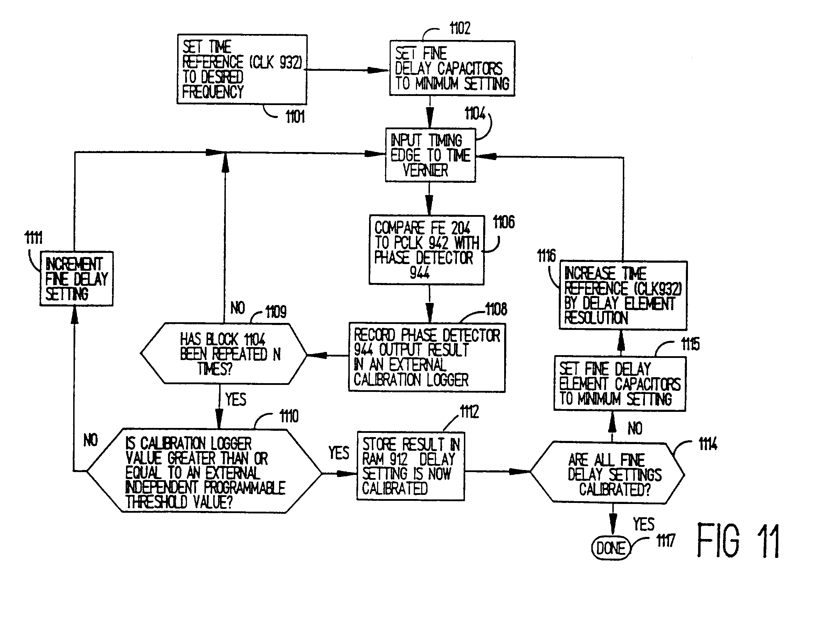

Figure 11 is a flow chart of a method of Fine Delay calibration which compensates for device mismatch in the fine delay elements. In essence, the fine delay elements are calibrated for on-chip photolithography variations. The Fine Delay calibration procedure begins with block 1101 by setting a time reference (CLK 932) to a desired frequency. As an ongoing example to assist in explaining this method, if a desired delay to be calibrated is 8 ns, then the time reference CLK 932 should be set with a period of 8 ns. This setting means that the time between one rising edge and a consecutive rising edge is 8 ns. Next, block 1102 shows that the capacitor settings for the fine delay elements, contained within the PNMOS wired-OR tapped delay line, are set to the minimum setting. For the ongoing example this would correspond to a fine delay of less than 8 ns.

Next, block 1104 indicates that a timing edge is input to the time vernier 106 via the input signal 203. Block 1106 illustrates that the delayed edge, FE output 204, is compared to the PCLK 942 (which is generated from time reference CLK 932 and has an identical clock period) by the phase detector 944. As mentioned in the description of Figure 9, the PHDOUT output signal 946 specifies a logic "1" if the delay from the delay line 206 on FE signal 204 is less than one clock period of signal PCLK 942; otherwise, the PHDOUT output signal 946 specifies a logic "0". The external calibration logger then records the PHDOUT output signal 946 as indicated by block 1108, thereby counting the number of times the output is high.

Decision block 1109 indicates that the process from block 1104 is repeated N times, where N is a digital number programmed into the calibration logger. The repeat of this cycle from block 1104 to 1109 is necessary when the delay of the delay line 206 approaches the period of the time reference CLK 932, because at this point the phase detector 944 enters an instability mode where the output becomes uncertain; therefore the output must be determined by probability. Hence, as N increases, the probability that the output is correctly determined increases.

At decision block 1110, the system determines if the count value stored as a calibration logger value, which represents the total number of times that the phase detector 944 returned a logic "1" result, is greater than or equal to an external independent programmable threshold value. If not, as shown by block 1191, the fine delay element capacitors are incremented by one setting, and the process repeats from block 1104. If the decision in block 1110 is a "yes", then block 1112 shows that the first fine delay setting is now calibrated to the desired fine delay with respect to on-chip photolithography variations, and this result is stored in the RAM 912.

Since the method involves multiple fine delay settings, decision block 1114 checks whether all fine delay settings have been calibrated. If not, the fine delay element capacitors are switched to a minimum setting, as shown at block 1115. Then, the time reference CLK 932 is increased by one delay element resolution, as shown at block 1116. The process is then repeated from block 1104 for this next fine delay setting. As block 1117 shows, the fine delay element calibration method is complete when all fine delay settings are calibrated.

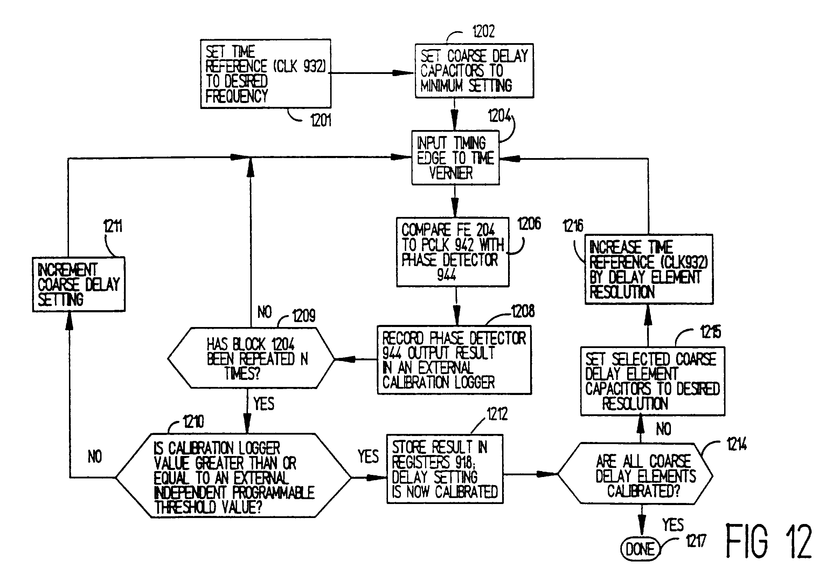

Figure 12 is a flow chart of a preferred method of Coarse Delay calibration which compensates for device mismatch in the coarse delay elements. In essence, the coarse delay elements are calibrated for on-chip photolithography variations, and variations through the tapped delay line. The Coarse Delay calibration procedure begins with block 1201 by setting a time reference (CLK 932) to a desired frequency. Next, block 1202 shows that the capacitor settings of a first coarse delay element internal to the PNMOS wired-OR Tapped Delay Line 206 are programmed to their minimum setting. Note that this minimum setting corresponds to an overall delay of less than the "desired delay".

The Coarse Delay calibration procedure shown in blocks 1204-1211 is very similar to the procedure discussed above in connection with Figure 11, blocks 1104-1111. A detailed discussion of blocks 1204-1211 will therefore be omitted. However, if the decision in block 1210 is a "yes", then the first coarse delay element is calibrated to the desired coarse delay with respect to on-chip photolithography variations, and this result is stored in the registers 918, as shown at block 1212.

Since the method Figure 12 could involve multiple coarse delay elements, decision block 1214 checks whether all coarse delay elements have been calibrated. If not, the fine delay element capacitors are switched to a desired resolution, as shown at step 1215. Then the time reference CLK 932 is increased by one delay element resolution, as shown at block 1216, which in effect includes a next coarse delay element into the calibration. The process is then repeated from block 1204 for this next coarse delay element. As block 1217 shows, the coarse delay element calibration method is complete when all coarse delay elements are calibrated.

## Claims

1. A time vernier system (101) for adding a time delay to an input signal (203), wherein the time delay corresponds to a predetermined time delay control signal (306 and 748), comprising:

   (a) means (104) for generating an adjustable control voltage (112) for use by the system to compensate for temperature and power supply variations and component tolerance variables due to manufacturing; and
   (b) a time vernier subsystem (106) having,

      (i) a first input to receive the input signal (203);
      (ii) a second input to receive the predetermined time delay control signal (306 and 748);
      (iii) a third input to receive said adjustable control voltage (112); and
      (iv) a means (206), coupled to said first through third inputs, for applying a time delay to the input signal according to the predetermined time delay control signal and maintaining the time delay using said adjustable control voltage.

2. The system of claim 1, wherein said system further comprises a plurality of time vernier subsystems (106,108, and 110) each of said plurality of subsystems receiving a further input signal and a corresponding further predetermined time delay control signal (306), wherein each of said plurality of subsystems applies a time delay to the respective further input signal according to the respective predetermined time delay control signal and maintains the time delay using said adjustable control voltage (112).

3. The system of claim 1, wherein said means further comprises:

   (a) a pseudo-PMOS delay line (206) comprising,

      (i) a plurality of serially coupled pseudo-PMOS fine delay elements (706, 708 and 714) for generating a fine delay aspect; and
      (ii) a plurality of serially coupled pseudo-PMOS coarse delay elements (716, 718 and 726) for generating a coarse delay aspect;

      wherein said plurality of fine delay elements are serially coupled to said plurality of coarse delay elements;

   (b) first decoder means (924) coupled to said plurality of pseudo-PMOS fine delay elements and to said second input to receive and binary decode the predetermined time delay control signal for controlling said plurality of pseudo-PMOS fine delay elements to produce said fine delay aspect; and

   (c) second decoder means (910) coupled to said plurality of pseudo-PMOS coarse delay elements and to said second input to receive and thermometer decode the predetermined time delay control signal for controlling said plurality of pseudo-PMOS coarse delay elements to produce said coarse delay aspect.

4. The system of claim 3, wherein said pseudo-PMOS fine and coarse delay elements further comprise:

(a) a first inverter (307) having:

a first input to receive said adjustable control signal;
a second input to receive the input signal; and
an output;

(b) a second inverter (314) having:

a first input to receive said adjustable control signal;
a second input electrically connected to said output of said first invertor to thereby form a node (310); and
an output; and

(c) a capacitor bank (308) connected to said node to provide said respective delay aspect according to said first and second decoder means, respectively.

5. A method for adding a time delay to an input signal, wherein the time delay corresponds to a predetermined time delay control signal (306, 748), comprising the steps of:

(1) generating an adjustable control voltage (112) to compensate for temperature and power supply variations and component tolerance variables due to manufacturing;
(2) receiving the input signal;
(3) receiving the predetermined time delay control signal;
(4) receiving said adjustable control voltage;
(5) applying a time delay to the input signal to generate a delayed signal (204), according to the predetermined time delay control signal and maintaining the time delay using said adjustable control voltage; and
(6) outputting said delayed signal.

6. The method of claim 5, further comprising the steps of:

(7) receiving a plurality of further input signals and corresponding further predetermined time delay control signals;
(8) applying a further time delay to each of said plurality of further input signals to generate further delayed signals, according to said corresponding further predetermined time delay control signals; and
(9) maintaining said further time delays using said adjustable control voltage; and
(10) outputting said further delayed signals.

7. The method of claim 5, further comprising the steps of:

(7) decoding the predetermined time delay control signal (922) for controlling a plurality of pseudo-PMOS fine delay elements to produce a fine delay aspect;
(8) decoding the predetermined time delay control signal (911) for controlling a plurality of pseudo-PMOS coarse delay elements to produce a coarse delay aspect; and
(9) combining said fine delay aspect and said coarse delay aspect to generate said time delay.

8. The method of claim 7, wherein step 7 is performed using binary decoding and step 8 is performed using thermometer decoding.

**Patentansprüche**

1. Ein Zeitfeineinstellsystem (101) zum Addieren einer Zeitverzögerung zu einem Eingangssignal (203), wobei die Zeitverzögerung einem vorbestimmten Zeitverzögerungssteuersignal (306 und 748) entspricht, wobei das System folgende Merkmale aufweist:

(a) eine Einrichtung (104) zum Erzeugen einer einstellbaren Steuerspannung (112) für eine Verwendung durch das System, um Temperatur- und Leistungsversorgungsänderungen und Komponententoleranzvariablen aufgrund der Herstellung zu kompensieren; und

(b) ein Zeitfeineinstelluntersystem (106) mit

(i) einem ersten Eingang, um das Eingangssignal (203) zu empfangen;

(ii) einem zweiten Eingang, um das vorbestimmte Zeitverzögerungssteuersignal (306 und 748) zu empfangen;

(iii) einem dritten Eingang, um die einstellbare Steuerspannung (112) zu empfangen; und

(iv) einer Einrichtung (206), die mit dem ersten bis dritten Eingang gekoppelt ist, zum Anlegen einer Zeitverzögerung an das Eingangssignal gemäß einem vorbestimmten Zeitverzögerungssteuersignal und zum Beibehalten der Zeitverzögerung unter Verwendung der einstellbaren Steuerspannung.

2. Das System gemäß Anspruch 1, bei dem das System ferner eine Mehrzahl von Zeitfeineinstelluntersystemen (106, 108 und 110) aufweist, wobei jedes der Mehrzahl von Untersystemen ein weiteres Eingangssignal und ein entsprechendes weiteres vorbestimmtes Zeitverzögerungssteuersignal (306) empfängt, wobei jedes der Mehrzahl von Untersystemen eine Zeitverzögerung an das jeweilige weitere Eingangssignal gemäß dem jeweiligen vorbestimmten Zeitverzögerungssteuerungssignal anlegt und die Zeitverzögerung unter Verwendung der einstellbaren Steuerspannung (112) beibehält.

3. Das System gemäß Anspruch 1, bei dem die Einrichtung ferner folgende Merkmale aufweist:

(a) eine Pseudo-PMOS-Verzögerungsleitung (206) mit

(i) einer Mehrzahl von seriell gekoppelten Pseudo-PMOS-Feinverzögerungselementen (706, 708 und 714) zum Erzeugen eines Feinverzögerungsaspekts; und

(ii) einer Mehrzahl von seriell gekoppelten Pseudo-PMOS-Grobverzögerungselementen (716, 718 und 726) zum Erzeugen eines Grobverzögerungsaspekts;

wobei die Mehrzahl von Feinverzögerungselementen mit der Mehrzahl von Grobverzögerungselementen seriell gekoppelt ist;

(b) eine erste Decodiereinrichtung (924), die mit der Mehrzahl von Pseudo-PMOS-Feinverzögerungselementen und dem zweiten Eingang gekoppelt ist, um das vorbestimmte Zeitverzögerungssteuersignal zu empfangen und binär zu decodieren, zum Steuern der Mehrzahl von Pseudo-PMOS-Feinverzögerungselementen, um den Feinverzögerungsaspekt zu erzeugen; und

(c) eine zweite Decodiereinrichtung (910), die mit der Mehrzahl von Pseudo-PMOS-Grobverzögerungselementen und dem zweiten Eingang gekoppelt ist, um das vorbestimmte Zeitverzögerungssteuersignal zu empfangen und zu Thermometer-decodieren, zum Steuern der Mehrzahl von Pseudo-PMOS-Grobverzögerungselementen, um den Grobverzögerungsaspekt zu erzeugen.

4. Das System gemäß Anspruch 3, bei dem die Pseudo-PMOS-Fein/Grob-Verzögerungselemente ferner folgende Merkmale aufweisen:

(a) einen ersten Invertierer (307) mit

einem ersten Eingang, um das einstellbare Steuersignal zu empfangen;

einem zweiten Eingang, um das Eingangssignal zu empfangen; und

einem Ausgang;

(b) einen zweiten Invertierer (314) mit

einem ersten Eingang, um das einstellbare Steuersignal zu empfangen;

einem zweiten Eingang, der mit dem Ausgang des ersten Invertierers elektrisch verbunden ist, um dadurch einen Knoten (310) zu bilden; und

einem Ausgang; und

(c) eine Kondensatorbankschaltung (308), die mit dem Knoten verbunden ist, um den jeweiligen Verzögerungsaspekt gemäß der ersten und zweiten Decodiereinrichtung zu liefern.

5. Ein Verfahren zum Addieren einer Zeitverzögerung zu einem Eingangssignal, bei dem die Zeitverzögerung einem vorbestimmten Zeitverzögerungssteuersignal (306, 748) entspricht, wobei das Verfahren folgende Schritte aufweist:

(1) Erzeugen einer einstellbaren Steuerspannung (112), um Temperatur- und Leistungsversorgungsänderungen und Komponententoleranzvariablen aufgrund der Herstellung zu kompensieren;

(2) Empfangen des Eingangssignals;

(3) Empfangen des vorbestimmten Zeitverzögerungssteuersignals;

(4) Empfangen der einstellbaren Steuerspannung;

(5) Anlegen einer Zeitverzögerung an das Eingangssignal, um ein verzögertes Signal (204) zu erzeugen, gemäß dem vorbestimmten Zeitverzögerungssteuersignal und Beibehalten der Zeitverzögerung unter Verwendung der einstellbaren Steuerspannung; und

(6) Ausgeben des verzögerten Signals.

6. Das Verfahren gemäß Anspruch 5, das ferner folgende Schritte aufweist:

(7) Empfangen einer Mehrzahl von weiteren Eingangssignalen und entsprechenden weiteren vorbestimmten Zeitverzögerungssteuersignalen;

(8) Anlegen einer weiteren Zeitverzögerung an jedes der Mehrzahl von weiteren Eingangssignalen, um weitere verzögerte Signale zu erzeugen, gemäß den entsprechenden weiteren vorbestimmten Zeitverzögerungssteuerungssignalen; und

(9) Beibehalten der weiteren Zeitverzögerungen unter Verwendung der einstellbaren Steuerspannung; und

(10) Ausgeben der weiteren verzögerten Signale.

7. Das Verfahren gemäß Anspruch 5, das ferner folgende Schritte aufweist:

(7) Decodieren des vorbestimmten Zeitverzögerungssteuersignals (922) zum Steuern einer Mehrzahl von Pseudo-PMOS-Feinverzögerungselementen, um einen Feinverzögerungsaspekt zu erzeugen;

(8) Decodieren des vorbestimmten Zeitverzögerungssteuersignals (911) zum Steuern einer Mehrzahl von Pseudo-PMOS-Grobverzögerungselementen, um einen Grobverzögerungsaspekts zu erzeugen; und

(9) Kombinieren des Feinverzögerungsaspekts und des Grobverzögerungsaspekts, um die Zeitverzögerung zu erzeugen.

8. Das Verfahren gemäß Anspruch 7, bei dem der Schritt 7 unter Verwendung einer binären Decodierung und der Schritt 8 unter Verwendung einer Thermometerdecodierung durchgeführt werden.

## Revendications

1. Un système (101) de vernier temporel pour ajouter un retard de temps à un signal d'entrée (203), dans lequel le retard de temps correspond à un signal prédéterminé de commande (306 et 748) de retard de temps, comprenant:

(a) un moyen (104) de génération d'une tension de commande réglable (112) à utiliser par le système pour compenser quant à des variations de températures et d'alimentation en énergie et des variables de tolérances de composants dues à la fabrication; et

(b) un sous-système (106) de vernier temporel qui inclut,

(i) une première entrée pour recevoir le signal d'entrée (203);

(ii) une deuxième entrée pour recevoir le signal prédéterminé (306 et 748) de commande de retard de temps;

(iii) une troisième entrée pour recevoir ladite tension de commande réglable (112); et

(iv) un moyen (206), couplé auxdites première, deuxième et troisième entrées, pour appliquer au signal d'entrée un retard de temps en fonction du signal prédéterminé de commande de retard de temps et pour maintenir le retard de temps en utilisant ladite tension de commande réglable.

2. Le système selon la revendication 1, dans lequel ledit système comprend en outre une série de sous-systèmes (106, 108 et 110) de verniers temporels, chaque sous-système de ladite série recevant un autre signal d'entrée et un autre signal prédéterminé correspondant (306) de commande de retard de temps, dans lequel chaque sous-système de ladite série applique un retard de temps à l'autre signal d'entrée respectif en fonction du signal prédéterminé respectif de commande de retard de temps et maintient le retard de temps en utilisant ladite tension de commande réglable (112).

3. Le système selon la revendication 1, dans lequel ledit autre moyen comprend:

(a) une ligne de retard (206) pseudo-PMOS comprenant,

(i) une série d'éléments de retard fin (706, 708 et 714) pseudo-PMOS couplés sériellement pour engendrer un aspect de retard fin; et

(ii) une série d'éléments de retard approximatif (716, 718 et 726) pseudo-PMOS couplés sériellement pour engendrer un aspect de retard approximatif;

dans lequel ladite série d'éléments de retard fin est couplée sériellement à ladite série d'éléments de retard approximatif;

(b) un premier moyen décodeur (224) couplé à ladite série d'éléments de retard fin pseudo-PMOS et à ladite deuxième entrée pour recevoir le signal prédéterminé de commande de retard de temps et le décoder en binaire afin de commander ladite série d'éléments de retard fin pseudo-PMOS pour produire ledit aspect de retard fin; et

(c) un deuxième moyen décodeur (910) couplé à ladite série d'éléments de retard approximatif pseudo-PMOS et à ladite deuxième entrée pour recevoir le signal prédéterminé de commande de retard de temps et le décoder en thermomètre afin de commander ladite série d'éléments de retard approximatif pseudo-PMOS pour produire ledit aspect de retard approximatif.

4. Le système selon la revendication 3, dans lequel lesdits éléments de retard fin et approximatif comprennent en outre:

(a) un premier inverseur (307) incluant:

une première entrée pour recevoir ledit signal de commande réglable;

une deuxième entrée pour recevoir le signal d'entrée; et une sortie;

(b) un deuxième inverseur (314) incluant:

une première entrée pour recevoir ledit signal de commande réglable;

une deuxième entrée connectée électriquement à ladite sortie dudit premier inverseur pour former ainsi un noeud (310); et une sortie; et

(c) une batterie (308) de condensateurs connectée audit noeud pour produire ledit aspect de retard respectif en fonction desdits premier et deuxième moyens décodeurs, respectivement.

**5.** Un procédé d'addition d'un retard de temps à un signal d'entrée, dans lequel le retard de temps correspond à un signal prédéterminé de commande (306, 748) de retard de temps, comprenant les étapes consistant à:

(1) engendrer une tension de commande réglable (112) pour compenser quant à des variations de température et d'alimentation et à des variables de tolérances de composantes dues à la fabrication;
(2) recevoir le signal d'entrée,
(3) recevoir le signal prédéterminé de commande de retard de temps
(4) recevoir ladite tension de commande réglable;
(5) appliquer un retard de temps au signal d'entrée pour engendrer un signal retardé (204), en fonction du signal prédéterminé de commande de retard de temps, et maintenir le retard de temps en utilisant ladite tension de commande réglable;
(6) sortir ledit signal retardé.

**6.** Le procédé selon la revendication 5, comprenant en outre les étapes consistant à:

(7) recevoir une série d'autres signaux d'entrée et d'autres signaux prédéterminés correspondants de commande de retard de temps;
(8) appliquer un autre retard de temps à chaque signal de ladite série d'autres signaux d'entrée pour engendrer d'autres signaux retardés, en fonction desdits autres signaux prédéterminés correspondants de commande de retard de temps; et
(9) maintenir lesdits autres retards de temps en utilisant ladite tension de commande réglable; et (10) sortir lesdits autres signaux retardés.

**7.** Le procédé selon la revendication 5, qui comprend en outre les étapes consistant à:

(7) décoder le signal prédéterminé (922) de commande de retard de temps pour commander une série d'éléments de retard fin pseudo-PMOS pour produire un aspect de retard fin;
(8) décoder le signal prédéterminé (911) de commande de retard de temps pour commander une série d'éléments de retard approximatif pseudo-PMOS pour produire un aspect de retard approximatif; et
(9) combiner ledit aspect de retard fin et ledit aspect de retard approximatif pour engendrer ledit retard de temps.

**8.** Le procédé selon la revendication 7, dans lequel l'étape 7 est effectuée en utilisant un décodage en binaire et l'étape 8 est exécutée en utilisant un décodage en thermomètre.

FIG 1

EP 0 539 832 B1

TIME VERNIER SYSTEM ⌐ 106

112

PCNTRL ⟶

DELAY LINE AND SUPPORT CIRCUITRY ⌐ 206

208

DELAY ELEMENTS • • •

210 212 214

216

215

PNMOS WIRED-OR MUX

204

OUTPUT SIGNAL

203

INPUT SIGNAL

FIG 2

EP 0 539 832 B1

FIG 3

EP 0 539 832 B1

FIG 4

FIG 5

FIG 6

EP 0 539 832 B1

FIG 7

FIG 8

EP 0 539 832 B1

FIG 9

EP 0 539 832 B1

SET TIME REFERENCE (CLK 932) TO DESIRED FREQUENCY — 1001

SET PCNTRL TO MINIMUM SETTING — 1002

INPUT TIMING EDGE TO TIME VERNIER — 1004

COMPARE FE204 TO PCLK 942 WITH PHASE DETECTOR 944 — 1006

RECORD PHASE DETECTOR 944 OUTPUT RESULT IN AN EXTERNAL CALIBRATION LOGGER — 1008

HAS BLOCK 1104 BEEN REPEATED N TIMES? — 1009
NO / YES

IS CALIBRATION LOGGER VALUE GREATER THAN OR EQUAL TO AN EXTERNAL INDEPENDENT PROGRAMMABLE THRESHOLD VALUE? — 1010
NO / YES

INCREMENT DAC SETTING — 1011

DONE: EACH DELAY ELEMENT IS EQUAL TO THE NOMINAL DELAY — 1012

FIG 10

EP 0 539 832 B1

SET TIME REFERENCE (CLK 932) TO DESIRED FREQUENCY — 1101

1102 — SET FINE DELAY CAPACITORS TO MINIMUM SETTING

1104 — INPUT TIMING EDGE TO TIME VERNIER

1106 — COMPARE FE 204 TO PCLK 942 WITH PHASE DETECTOR 944

1108 — RECORD PHASE DETECTOR 944 OUTPUT RESULT IN AN EXTERNAL CALIBRATION LOGGER

1109 — HAS BLOCK 1104 BEEN REPEATED N TIMES?

NO → 1111 — INCREMENT FINE DELAY SETTING

YES → 1110 — IS CALIBRATION LOGGER VALUE GREATER THAN OR EQUAL TO AN EXTERNAL INDEPENDENT PROGRAMMABLE THRESHOLD VALUE?

NO → (back to INPUT TIMING EDGE TO TIME VERNIER)

YES → 1112 — STORE RESULT IN RAM 912 DELAY SETTING IS NOW CALIBRATED

1114 — ARE ALL FINE DELAY SETTINGS CALIBRATED?

NO → 1115 — SET FINE DELAY ELEMENT CAPACITORS TO MINIMUM SETTING

1116 — INCREASE TIME REFERENCE (CLK932) BY DELAY ELEMENT RESOLUTION

YES → DONE — 1117

FIG 11

1201 SET TIME REFERENCE (CLK 932) TO DESIRED FREQUENCY

1202 SET COARSE DELAY CAPACITORS TO MINIMUM SETTING

1204 INPUT TIMING EDGE TO TIME VERNIER

1206 COMPARE FE 204 TO PCLK 942 WITH PHASE DETECTOR 944

1208 RECORD PHASE DETECTOR 944 OUTPUT RESULT IN AN EXTERNAL CALIBRATION LOGGER

1209 HAS BLOCK 1204 BEEN REPEATED N TIMES?

NO

1211 INCREMENT COARSE DELAY SETTING

YES

1210 IS CALIBRATION LOGGER VALUE GREATER THAN OR EQUAL TO AN EXTERNAL INDEPENDENT PROGRAMMABLE THRESHOLD VALUE?

NO

YES

1212 STORE RESULT IN REGISTERS 918; DELAY SETTING IS NOW CALIBRATED

1214 ARE ALL COARSE DELAY ELEMENTS CALIBRATED?

NO

1215 SET SELECTED COARSE DELAY ELEMENT CAPACITORS TO DESIRED RESOLUTION

1216 INCREASE TIME REFERENCE (CLK932) BY DELAY ELEMENT RESOLUTION

YES 1217 DONE

FIG 12